# EUROPEAN PATENT SPECIFICATION

(11) **EP 3 591 725 B1**
(45) Date of publication and mention of the grant of the patent: **23.09.2026**
(21) Application number: 18181179.5
(22) Date of filing: 02.07.2018
(51) Int. Cl.: H10K 85/30, H10K 50/155, H10K 50/17

(54) **ELECTRONIC DEVICE, METHOD FOR PREPARING THE SAME AND A DISPLAY DEVICE COMPRISING THE SAME**
ELEKTRONISCHE VORRICHTUNG, VERFAHREN ZU IHRER HERSTELLUNG UND ANZEIGEVORRICHTUNG DAMIT
DISPOSITIF ÉLECTRONIQUE, SON PROCÉDÉ DE PRÉPARATION ET DISPOSITIF D'AFFICHAGE LE COMPRENANT

(43) Date of publication of application: 08.01.2020
(73) Proprietor: Novaled GmbH, 01099 Dresden (DE)
(72) Inventor: HUMMERT, Markus, 01099 Dresden (DE); SENKOVSKYY, Volodymyr, 01099 Dresden (DE)
(74) Representative: Bittner, Thomas L.

(56) References cited:
- EP-A1- 2 595 997
- DE-A1- 102007 031 261
- DE-A1- 102011 003 192
- US-A1- 2011 155 954
- US-A1- 2013 334 516
- KIRLIKOVALI KENT O. ET AL: "Luminescent metal complexes featuring photophysically innocent boron cluster ligands", CHEMICAL SCIENCE, vol. 7, no. 8, 27 April 2016 (2016-04-27), United Kingdom, pages 5132 - 5138, XP093229790, ISSN: 2041-6520, DOI: 10.1039/C6SC01146B

## Description

The present invention relates to an electronic device, a display device comprising the electronic device and a method for preparing the electronic device, a semiconducting material and use of a compound.

### BACKGROUND ART

Organic light-emitting diodes (OLEDs), which are self-emitting devices, have a wide viewing angle, excellent contrast, quick response, high brightness, excellent driving voltage characteristics, and color reproduction. A typical OLED includes an anode, a hole transport layer (HTL), an emission layer (EML), an electron transport layer (ETL), and a cathode, which are sequentially stacked on a substrate. In this regard, the HTL, the EML, and the ETL are thin films formed from organic and / or organometallic compounds.

When a voltage is applied to the anode and the cathode, holes injected from the anode electrode move to the EML, via the HTL, and electrons injected from the cathode electrode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency.

WO 2013/079676 discloses organic electronic devices and the use of metal borate complexes as n-dopants in electron transport materials thereof.

US 2011/155954 A1 discloses mononuclear, neutral copper (1) complexes having a bidentate ligand that binds via nitrogen, and two phosphane or arsane ligands, to the use thereof for producing electronic components, and to electronic devices comprising said complexes.

DE 10 2007 031261 A1 discloses auxiliary ligands for luminescent metal complexes, emitter complexes comprising such auxiliary ligands, as well as light-emitting devices and in particular organic light-emitting devices (OLED) comprising metal complexes which have the auxiliary ligands according to the invention.

DE 10 2011 003192 A1 discloses an organic semiconductor component with a hole-conducting layer with a superacid salt.

US 2013/334516 A1 discloses an organic electronic or optoelectronic component, comprising an electrode and a counter-electrode and a layer system between the electrode and the counter-electrode, wherein the layer system contains at least one organic layer and at least one doped layer, wherein the dopant in the doped layer represents a stronger Lewis acid than antimony pentafluoride (SbF₅) or a stronger Lewis base than 1,8-bis(dimethylamino)napthalene based on the calculation of fluoride ion affinity.

KIRLIKOVALI KENT O. ET AL, CHEMICAL SCIENCE, vol. 7, no. 8, 27 April 2016 (2016-04-27), pages 5132-5138, discloses luminescent metal complexes featuring photophysically innocent boron cluster ligands.

There is a need to improve the performance of electronic devices and/or optoelectronic devices, in particular in optoelectronic devices comprising an organic charge transport material, such as organic light emitting diodes (OLEDs) or organic photovoltaic (OPV) devices and in complex devices comprising the said optoelectronic devices, such as OLED displays.

It is, therefore, the object of the present invention to provide an electronic device and a method for preparing the same overcoming drawbacks of the prior art, in particular to provide electronic devices comprising novel charge transport materials, organic charge injection materials or charge generating materials, for improving the performance of the device, in particular having excellent voltage and efficiency and improved device lifetime.

### SUMMARY OF THE INVENTION

The above object is achieved by an electronic device comprising, between a first electrode and a second electrode, at least one first semiconducting layer, the first semiconducting layer comprising (i) at least one first charge transport matrix compound consisting of covalently bound atoms and (ii) at least one electrical which is non-emissive, wherein the electrical dopant comprises at least one metal cation selected from Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), Al(III); rare earth metal in oxidation state (III), V(III), Nb(III), Ta(III), Cr(III), Mo(III), W(III) Ga(III), In(III); Ti(IV), Zr(IV), Hf(IV) Sn(IV), or a mixture thereof and at least one anionic ligand consisting of covalently bound atoms, wherein the anionic ligand comprises at least two boron atoms linked to each other via a covalent bond, wherein the first semiconducting layer is a charge injection layer, a part of a charge generating layer, a charge transport layer or two or more thereof; and the first semiconducting layer is non-emissive.

It is to be understood that the term "semiconducting" encompasses materials and/or devices with electronic mechanism of conductivity. Electric current in semiconductors can be interpreted by flow of mobile electrons. This is a striking difference from electrical devices exploiting ion conductivity. Such devices, for example galvanic cells, comprise an electrolyte with mobile ions, and electrical current therein is accompanied by ion flow through the electrolyte.

Under covalent bond, it is to be understood any bonding interaction which involves electron density sharing between the two assessed atoms, wherein the bonding is stronger than van der Waals dispersive interactions; for the sake of simplicity, binding energy 10 kJ/mol may be taken as an arbitrary lower limit. In this sense, the term includes also coordination bonds or hydrogen bonds. Anions and/or anionic ligands comprising hydrogen bonds, however, are not particularly preferred.

It is to be understood that the term "electrical properties" refers to injection and/or transport of electrons in the semiconducting material and layer.

It is to be understood that the term "electrical dopant" refers to a compound which improves the electrical properties of a semiconducting material and/or layer. As a result, conductivity, operating voltage, voltage rise over time, efficiency and or lifetime may be improved. The electrical dopant is non-emissive.

The inventive electronic device is an electronic device comprising at least one layer, normally a variety of layers. These layers may, for example, be prepared by evaporating a chemical compound and depositing the same on a substrate (or a foregoing layer) to form the layer. According to the invention, at least one of the layers comprised in the electronic device comprises an electrical dopant. It might be provided that "comprising" is "consisting of", i.e. the layer consists only of the borate salt (except for impurities which cannot be avoided by conventional technical means) for example in case in which the first semiconducting layer is a charge injection layer.

It was surprisingly found by the inventors that an electronic device comprising at least one layer comprising the electrical dopant, in particular in a charge injection layer, a charge transport layer or a charge generation layer thereof, shows superior properties over respective devices of the prior art, in particular with respect to device lifetime. These advantages are apparent from the specific examples presented herein.

The electrical dopant which may be embedded in the first charge transport matrix compound improves the electrical conductivity of the matrix material. The matrix material in such a layer is the predominant material.

In the electronic device, the at least one first semiconducting layer may be solid.

In the electronic device, the at least one first semiconducting layer may be amorphous. In this regard, a bulk material which has a glass transition temperature measured by a standard procedure above room temperature is supposed to form an amorphous layer if the layer is provided by the same procedure as the bulk material (e.g. vacuum deposition or by evaporation of solution of the material in a specific solvent). The standard procedure is described in the experimental part.

The organic semiconducting material and layer comprising at least one electrical dopant are non-emissive.

In the electronic device, the electrical dopant may be a metal salt, a metal complex or a mixture thereof. In this way, it is possible to further improve the properties of the electronic device, in particular with respect to operating voltage, efficiency and/or lifetime thereof.

In the electronic device, the anionic ligand may comprise at least 6, alternatively at least 7, alternatively at least 8, alternatively at least 9, alternatively at least 10, alternatively at least 11, alternatively at least 12 covalently bound boron atoms. In this way, it is possible to further improve the properties of the electronic device, in particular with respect to operating voltage, efficiency and/or lifetime thereof.

In the electronic device the anionic ligand may be selected from the group consisting of borate anions, heteroborate anions and mixtures thereof. In this way, it is possible to further improve the properties of the electronic device, in particular with respect to operating voltage, efficiency and/or lifetime thereof.

In the electronic device the anionic ligand may be selected from the group consisting of substituted and unsubstituted closo-dodecaborate dianions. In this way, it is possible to further improve the properties of the electronic device, in particular with respect to operating voltage, efficiency and/or lifetime thereof.

In the electronic device the anionic ligand may comprise substituents independently selected from
(i) H,
(ii) F,
(iii) CN,
(iv) C₆-C₆₀ aryl,
(v) C₇-C₆₀ arylalkyl,
(vi) C₁-C₆₀ alkyl,
(vii) C₂-C₆₀ alkenyl,
(viii) C₂-C₆₀ alkynyl,
(ix) C₃-C₆₀ cycloalkyl and
(x) C₂-C₆₀ heteroaryl;
wherein, with proviso that the overall count of carbon atoms in a carbon-containing group does not exceed 60, any hydrogen atom in any carbon containing group selected from (iv), (v), (vi), (vii), (viii), (ix) and (x) may be replaced by a substituent independently selected from F, Cl, Br, **I,** CN, unsubstituted or halogenated alkyl, unsubstituted or halogenated (hetero)aryl, unsubstituted or halogenated (hetero)arylalkyl, unsubstituted or halogenated alkylsulfonyl, unsubstituted or halogenated (hetero)arylsulfonyl, unsubstituted or halogenated (hetero)arylalkylsulfonyl, unsubstituted or halogenated boron-containing hydrocarbyl, unsubstituted or halogenated silicon-containing hydrocarbyl. In this way, it is possible to further improve the properties of the electronic device, in particular with respect to operating voltage, efficiency and/or lifetime thereof.

In the electronic device the anionic ligand may comprise at least one substituent selected from Cl, F, Br, I, CN, or an electron-withdrawing carbon group, wherein the electron-withdrawing carbon group may be a carbon group selected from hydrocarbyl, boron-containing hydrocarbyl, silicon-containing hydrocarbyl and heteroaryl and having at least one half of its hydrogen atoms replaced by F, Cl, Br, I CN or a mixture thereof. In this way, it is possible to further improve the properties of the electronic device, in particular with respect to operating voltage, efficiency and/or lifetime thereof.

In the electronic device the anionic ligand may be a dodecafluoro-closo-dodecaborate. In this way, it is possible to further improve the properties of the electronic device, in particular with respect to operating voltage, efficiency and/or lifetime thereof.

In the electronic device, the metal cation may be a non-oxidizing cation. Non-oxidizing in this regard means that the metal cation of the electrical dopant does not oxidize the matrix material or parts thereof. In this way, it is possible to further improve the properties of the electronic device, in particular with respect to operating voltage, efficiency and/or lifetime thereof.

In the electronic device the metal cation comprised in the electrical dopant is selected from Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), Al(III); rare earth metal in oxidation state (III), V(III), Nb(III), Ta(III), Cr(III), Mo(III), W(III) Ga(III), In(III); Ti(IV), Zr(IV), Hf(IV) Sn(IV); alternatively, the metal cation may be selected from Li, Na, K, Rb, Cs, Cu, or mixtures thereof; alternatively, the metal cation is selected from Be, Mg, Ca, Sr, Ba, Mn, Fe, Co, Ni, Cu, Zn, Cd or mixtures thereof; alternatively, the metal cation is selected from Li, Na, Cu, or mixtures thereof; alternatively, the metal cation is selected from Mg, Ca, Mn, Zn, Cu or mixtures thereof; alternatively, the metal cation is selected from Li , Mg, Mn, Zn or mixtures thereof. In this way, it is possible to further improve the properties of the electronic device, in particular with respect to operating voltage, efficiency and/or lifetime thereof.

In the electronic device the electrical dopant may be zinc dodecafluoro-closo-dodecaborate, ZnB₁₂F₁₂, lithium dodecafluoro-closo-dodecaborate; Li₂B₁₂F₁₂, or a mixture thereof. In this way, it is possible to further improve the properties of the electronic device, in particular with respect to operating voltage, efficiency and/or lifetime thereof.

In the electronic device the first charge transport matrix compound may have an energy level of its highest occupied molecular orbital computed by software package TURBOMOLE using DFT functional B3LYP with the basis set def2-TZVP and expressed in absolute vacuum scale more negative than -3.0 eV, alternatively more negative than -3.5 eV, alternatively more negative than -4.0 eV, alternatively more negative than -4.5 eV and alternatively more negative than -5.0 eV. In this way, it is possible to further improve the properties of the electronic device, in particular with respect to operating voltage, efficiency and/or lifetime thereof.

In the electronic device the first semiconducting layer may comprise a first sub-layer and a second sub-layer, wherein in the first sub-layer, the volume and/or mass fraction of the electrical dopant is higher than the volume and/or mass fraction of all other components comprised in the first sub-layer, and in the second sub-layer, the volume and/or mass fraction of the first charge transport matrix compound is higher than the volume and/or mass fraction of all other components comprised in the second sub-layer. In this way, it is possible to further improve the properties of the electronic device, in particular with respect to operating voltage, efficiency and/or lifetime thereof.

In the electronic device the electrical dopant may be a p-dopant and the first charge transport matrix compound may be a first hole transport compound; alternatively the first hole transport compound may be an organic compound comprising a conjugated system of at least 6, alternatively at least 10 delocalized electrons, alternatively an organic compound comprising at least one triaryl amine structural moiety, alternatively comprising at least two triaryl amine structural moieties. In this way, it is possible to further improve the properties of the electronic device, in particular with respect to operating voltage, efficiency and/or lifetime thereof.

In the electronic device the electrical p-dopant may have an energy level of its lowest unoccupied molecular orbital computed by software package TURBOMOLE V6.5 (TURBOMOLE GmbH, Litzenhardtstrasse 19, 76135 Karlsruhe, Germany) using DFT functional B3LYP with the basis set def2-TZVP and expressed in absolute vacuum scale of at least 0.5 eV, alternatively at least 0.6 eV, alternatively at least 0.8 eV, alternatively at least 1.0 eV, alternatively at least 1.2 eV less negative than the energy level of the highest occupied orbital of the first hole transport compound computed by software package TURBOMOLE using DFT functional B3LYP with the basis set def2-TZVP. In this way, it is possible to further improve the properties of the electronic device, in particular with respect to operating voltage, efficiency and/or lifetime thereof.

In the electronic device at least one light emitting layer or at least one light absorbing layer may be arranged between the first electrode and the second electrode, wherein the first electrode is an anode and the first semiconducting layer is arranged between the anode and the light emitting layer, respectively between the anode and the light absorbing layer. In this way, it is possible to further improve the properties of the electronic device, in particular with respect to operating voltage, efficiency and/or lifetime thereof.

In the electronic device the first semiconducting layer may be adjacent to the anode. In this way, it is possible to further improve the properties of the electronic device, in particular with respect to operating voltage, efficiency and/or lifetime thereof.

In the electronic device the electronic device may be an electroluminescent device; the electroluminescent device may be an organic light emitting diode. In this way, it is possible to further improve the properties of the electronic device, in particular with respect to operating voltage, efficiency and/or lifetime thereof.

The object is further achieved by a display device comprising at least two inventive electronic devices.

The at least two electronic devices comprised in the display device may share at least one layer comprising the electrical dopant.

The object is further achieved by a semiconducting material comprising (a) at least one first charge transport matrix compound consisting of covalently bound atoms and (b) at least one electrical dopant which is non-emissive, wherein the electrical dopant comprises at least one metal cation selected from Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), Al(III); rare earth metal in oxidation state (III), V(III), Nb(III), Ta(III), Cr(III), Mo(III), W(III) Ga(III), In(III); Ti(IV), Zr(IV), Hf(IV) Sn(IV); or a mixture thereof and at least one anionic ligand consisting of covalently bound atoms, wherein the anionic ligand comprises at least two boron atoms linked to each other via a covalent bond, wherein the semiconducting material is non-emissive.

The object is further achieved by a method for preparing an electronic device comprising a step of depositing the electrical dopant either by vacuum thermal evaporation or from a solution comprising the electrical dopant.

In the method depositing may be by vacuum thermal evaporation, the method comprising the steps: (i) evaporating the electrical dopant at an elevated temperature and, optionally, a reduced pressure; and (ii) depositing the evaporated borate salt on a solid support.

The object is further achieved by the use of a compound comprising at least one metal cation selected from Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), Al(III); rare earth metal in oxidation state (III), V(III), Nb(III), Ta(III), Cr(III), Mo(III), W(III) Ga(III), In(III); Ti(IV), Zr(IV), Hf(IV) Sn(IV); or a mixture thereof and at least one anionic ligand consisting of covalently bound atoms, wherein the anionic ligand may comprise at least two boron atoms linked to each other via a covalent bond, for improving injection and/or transport of electrons of a semiconducting material or in a layer of an electronic device comprising the compound, in comparison with the same semiconducting material and/or layer of the electronic device which does not comprise the compound.

### Further layers

In accordance with the invention, the electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

### Anode electrode

Either the first electrode or the second electrode may be an anode electrode. The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode electrode may also be formed using metals, typically silver (Ag), gold (Au), or metal alloys.

### Hole injection layer

In accordance with the invention, the hole injection layer may comprise the electrical dopant as described above in very detail. The hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed - in particular if the electronic device comprises another layer comprising the electrical dopant - of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

In such a case, the HIL may be a pure layer of p-dopant or may be selected from a hole-transporting matrix compound doped with a p-dopant. Typical examples of known redox doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = - 5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile (PD1). α-NPD doped with 2,2',2"-(cyclopropane-1,2,3-triylidene)tris(2-(p-cyanotetrafluorophenyl)acetonitrile) (PD2). Dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

### Hole transport layer

In accordance with the invention, the hole transport layer may comprise as the electrical dopant as described above in detail.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

In case that the HTL does not comprise the electrical dopant in accordance with the invention, but the electrical dopant is comprised in another layer, the HTL may be formed by any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

### Electron blocking layer

The function of the electron blocking layer (EBL) is to prevent electrons from being transferred from the emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

The electron blocking layer may comprise a compound of formula Z below (Z).

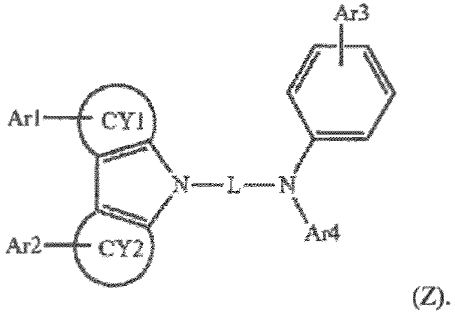

In Formula Z, CY1 and CY2 are the same as or different from each other, and each independently represent a benzene cycle or a naphthalene cycle, Ar1 to Ar3 are the same as or different from each other, and each independently selected from the group consisting of hydrogen; a substituted or unsubstituted aryl group having 6 to 30 carbon atoms; and a substituted or unsubstituted heteroaryl group having 5 to 30 carbon atoms, Ar4 is selected from the group consisting of a substituted or unsubstituted phenyl group, a substituted or unsubstituted biphenyl group, a substituted or unsubstituted terphenyl group, a substituted or unsubstituted triphenylene group, and a substituted or unsubstituted heteroaryl group having 5 to 30 carbon atoms, L is a substituted or unsubstituted arylene group having 6 to 30 carbon atoms.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Emission layer (EML)

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA), bis(2-(2-hydroxyphenyl)benzo-thiazolate)zinc (Zn(BTZ)₂), G3 below, AND, Compound 1 below, and Compound 2 below. 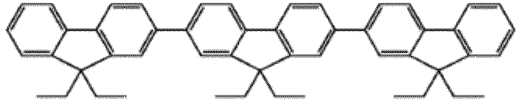
G3 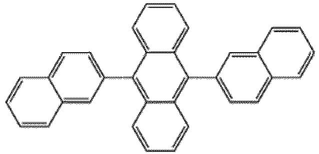
AND

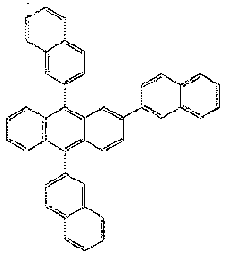

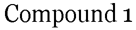

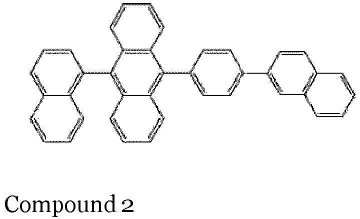

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)₃, and Btp₂lr(acac), but are not limited thereto. These compounds are phosphorescent emitters, however, fluorescent red emitter dopants could also be used.

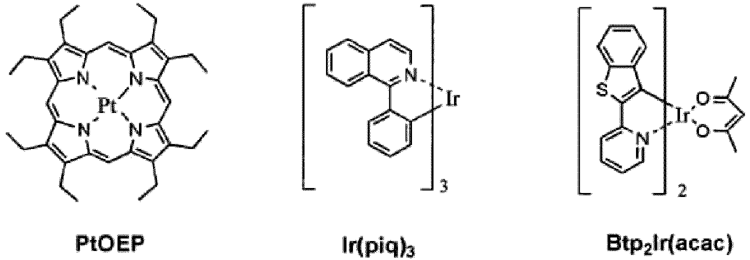

Examples of phosphorescent green emitter dopants are Ir(ppy)₃ (ppy = phenylpyridine), Ir(ppy)₂(acac), Ir(mpyp)₃ are shown below. Compound 3 is an example of a fluorescent green emitter and the structure is shown below.

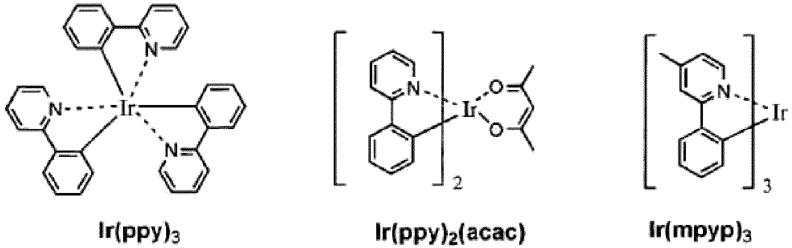

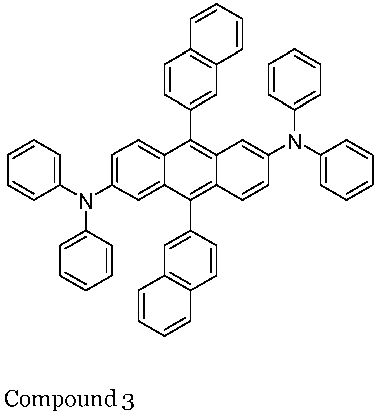

Examples of phosphorescent blue emitter dopants are F2Irpic, (F2ppy)2Ir(tmd) and Ir(dfppz)₃, ter-fluorene, the structures are shown below. 4.4'-bis(4-diphenyl amiostyryl)biphenyl (DPAVBi), 2,5,8,11-tetra-tert-butyl perylene (TBPe), and Compound 4 below are examples of fluorescent blue emitter dopants.

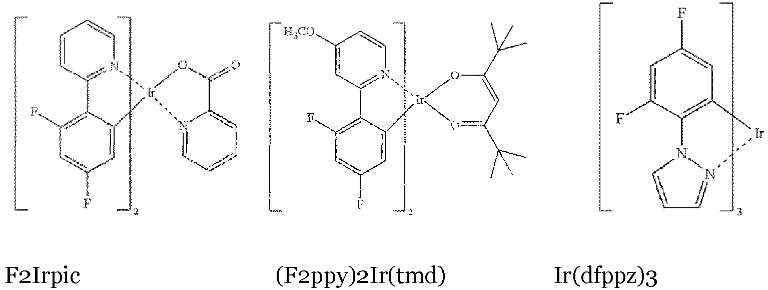

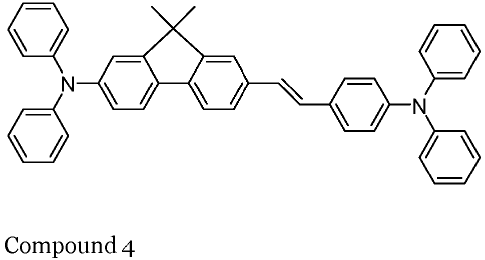

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, and phenanthroline derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The OLED according to the present invention may contain an electron transport layer (ETL).

According to various embodiments the OLED may comprises an electron transport layer or an electron transport layer stack comprising at least a first electron transport layer and at least a second electron transport layer.

By suitably adjusting energy levels of particular layers of the ETL, the injection and transport of the electrons may be controlled, and the holes may be efficiently blocked. Thus, the OLED may have long lifetime.

The electron transport layer of the electronic device may comprise an organic electron transport matrix (ETM) material. Further, the electron transport layer may comprise one or more n-dopants. Suitable compounds for the ETM are not particularly limited. In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/079217 A1.

### Electron injection layer (EIL)

The optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li₂O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode electrode

The cathode electrode is formed on the EIL if present. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

It is to be understood that the cathode electrode is not part of an electron injection layer or the electron transport layer.

### Charge generation layer/hole generation layer

The charge generation layer (CGL) may be composed of a double layer. The charge generation layer, in particular the p-type charge generation layer (hole generation layer), may comprise the electrical dopant.

Typically, the charge generation layer is a pn junction joining a n-type charge generation layer (electron generation layer) and a hole generation layer. The n-side of the pn junction generates electrons and injects them into the layer which is adjacent in the direction to the anode. Analogously, the p-side of the p-n junction generates holes and injects them into the layer which is adjacent in the direction to the cathode.

Charge generation layers are used in tandem devices, for example, in tandem OLEDs comprising, between two electrodes, two or more emission layers. In a tandem OLED comprising two emission layers, the n-type charge generation layer provides electrons for the first light emission layer arranged near the anode, while the hole generation layer provides holes to the second light emission layer arranged between the first emission layer and the cathode.

In accordance with the invention, it may be provided that the electronic device comprises a hole injection layer as well as a hole generation layer. If another layer than the hole generation layer comprises the electrical dopant, it is not obligatory that also the hole generation layer comprises the electrical dopant. In such a case, the hole generation layer can be composed of an organic matrix material doped with p-type dopant. Suitable matrix materials for the hole generation layer may be materials conventionally used as hole injection and/or hole transport matrix materials. Also, p-type dopant used for the hole generation layer can employ conventional materials. For example, the p-type dopant can be one selected from a group consisting of tetrafluore-7,7,8,8-tetracyanoquinodimethane (F4-TCNQ), derivatives of tetracyanoquinodimethane, radialene derivatives, iodine, FeCl₃, FeF₃, and SbCl₅. Also, the host can be one selected from a group consisting of N,N'-di(naphthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB).

In an embodiment, the hole generation layer comprises the electrical dopant as defined above in detail.

The n-type charge generation layer can be layer of a neat n-dopant, for example of an electropositive metal, or can consist of an organic matrix material doped with the n-dopant. In one embodiment, the n-type dopant can be alkali metal, alkali metal compound, alkaline earth metal, or alkaline earth metal compound. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Cs, K, Rb, Mg, Na, Ca, Sr, Eu and Yb. Suitable matrix materials for the electron generating layer may be the materials conventionally used as matrix materials for electron injection or electron transport layers. The matrix material can be for example one selected from a group consisting oftriazine compounds, hydroxyquinoline derivatives like tris(8-hydroxyquinoline)aluminum, benzazole derivatives, and silole derivatives.

In one embodiment, the n-type charge generation layer may include compounds of the following Chemical Formula X. 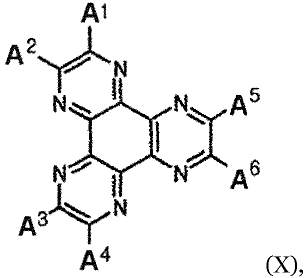 wherein each of A1 to A6 may be hydrogen, a halogen atom, nitrile (-CN), nitro (-NO2), sulfonyl (-SO2R), sulfoxide (-SOR), sulfonamide (-SO2NR), sulfonate (-SO3R), trifluoromethyl (-CF₃), ester (-COOR), amide (-CONHR or - CONRR'), substituted or unsubstituted straight-chain or branched-chain C1-C12 alkoxy, substituted or unsubstituted straight-chain or branched-chain C1-C12 alkyl, substituted or unsubstituted straight-chain or branched chain C2-C12 alkenyl, a substituted or unsubstituted aromatic or non-aromatic heteroring, substituted or unsubstituted aryl, substituted or unsubstituted mono- or di-arylamine, substituted or unsubstituted aralkylamine, or the like. Herein, each of the above R and R' may be substituted or unsubstituted C1-C60 alkyl, substituted or unsubstituted aryl, or a substituted or unsubstituted 5- to 7-membered heteroring, or the like.

An example of such n-type charge generation layer may be a layer comprising CNHAT

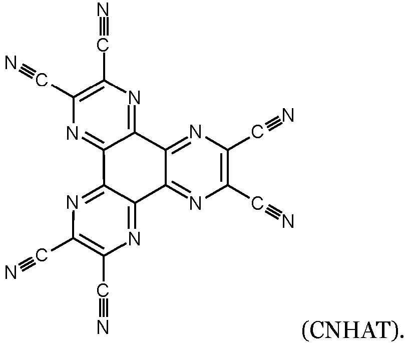

The hole generating layer is arranged on top of the n-type charge generation layer.

### Organic light-emitting diode (OLED)

According to one aspect of the present invention, there is provided an organic light-emitting diode (OLED) comprising: a substrate; an anode electrode formed on the substrate; a hole injection layer, a hole transport layer, an emission layer, and a cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer and a cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer, an electron transport layer, and a cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer, an electron transport layer, an electron injection layer, and a cathode electrode.

According to various embodiments of the present invention, there may be provided OLEDs comprising layers arranged between the above mentioned layers, on the substrate or on the top electrode.

According to one aspect, the OLED can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer, the n-type charge generation layer is adjacent arranged to a hole generating layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

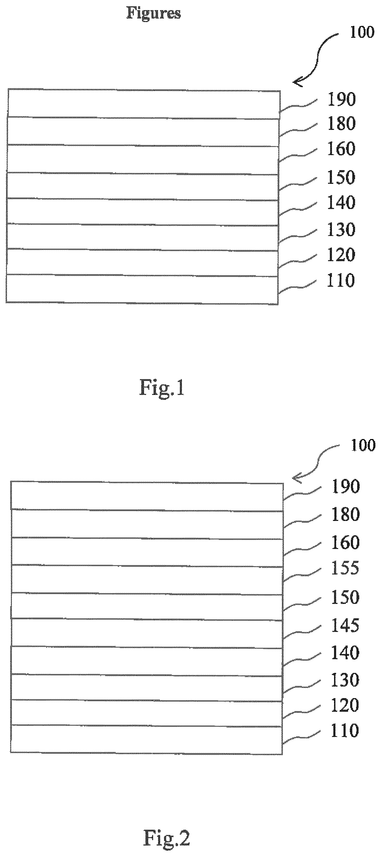

For example, the OLED according to Fig. 2 may be formed by a process, wherein on a substrate (110), an anode (120), a hole injection layer (130), a hole transport layer (140), an electron blocking layer (145), an emission layer (150), a hole blocking layer (155), an electron transport layer (160), an electron injection layer (180) and the cathode electrode (190) are subsequently formed in that order.

### Details and definitions of the invention

The electronic device of the present invention comprises at least one semiconducting layer comprising a charge transport matrix compound and an electrical dopant. The electrical dopant may be embedded in the matrix material, i.e. the matrix material is the predominant material in such a layer. Likewise, it may be provided that the matrix material and the dopant are separated from each other in the semiconducting layer in a first sublayer comprising the matrix material and a second sublayer comprising the dopant, or, in a preferred embodiment, respectively consisting thereof.

The electrical dopant may diffuse into the adjacent layers after deposition, in particular the electrical dopant may diffuse into the layer on which it is deposited.

The electrical dopant, also called a doping agent, may be mixed with the charge transport matrix compound in a concentration of less than 50 wt.-%, alternatively less than 50 vol.-%, to improve the electrical properties of the matrix. In particular, the electrical dopant is added into the charge transport matrix compound to improve the electrical conductivity of the semiconducting layer.

The electrical dopant of the present invention comprises at least one metal cation and at least one anionic ligand. The anionic ligand consists of covalently bound atoms. The anionic ligand comprises at least two boron atoms but may comprise more than two boron atoms. In the anionic ligand at least two of the boron atoms comprised therein are linked to each other via a covalent bond. That is, compounds comprising two or more boron atoms which are, however, not linked to each other via a covalent bond are explicitly excluded. Examples of anionic ligands addressed by the present invention are closo-dodecaborate dianions having the chemical formula B₁₂H₁₂²⁻ which are anionic molecules containing a symmetrical cluster of boron and hydrogen atoms. Further addressed are substituted derivatives of such closo-dodecaborate anions, such as dodecarfluoro-closo-dodecaborate anions (B₁₂F₁₂²⁻). However, the present invention is not limited to such compounds. Further addressed are heteroborates, for example closo-dodecaborate dianion derivatives in which at least one of the boron atoms is substituted by a heteroatom. As distinct chemical compound, the electrical dopant of the present invention may form a crystalline metal salt. The term "metal salt", as used herein, shall be understood to encompass a compound comprising positively charged metal cations and negatively charged anions, wherein the prevalent component of the lattice energy released during formation of the metal salt crystal from individual cations and anions results from electrostatic interaction of the oppositely charged ions. Besides typical metal salts which may consist of at least one metal cation and of the anionic ligand only, the electrical dopant of the present invention, if prepared as a distinct chemical compound, may be also a true metal complex. It is to be understood that in metal complexes at least one ligand is bound to the metal cation by at least one coordination bond. In this regard, it is to be understood that the coordination bond has prevalently covalent character. The ligand forming the coordination bond to the metal cation may be the anionic ligand comprising the at least two boron atoms linked to each other via a covalent bond. Alternatively or in addition, the electrical dopant of the present invention may comprise another anionic ligand, and/or an electrically neutral ligand. In this regard, it is to be understood that the number and/or the character of the ligands are not particularly limited, provided that the electrical dopant can be synthesized.

The term "hydrocarbyl group" as used herein shall be understood to encompass any organic group comprising carbon atoms, in particular organic groups, such as alkyl, aryl, heteroaryl, heteroalkyl, in particular such groups which are substituents usual in organic electronics.

The term "alkyl" as used herein shall encompass linear as well as branched and cyclic alkyl. For example, C₃-alkyl may be selected from n-propyl and iso-propyl. Likewise, C₄-alkyl encompasses n-butyl, sec-butyl and t-butyl. Likewise, C₆-alkyl encompasses n-hexyl and cyclo-hexyl.

The subscribed number n in Cₙ relates to the total number of carbon atoms in the respective alkyl, arylene, heteroarylene or aryl group.

The term "aryl" as used herein shall encompass phenyl (C₆-aryl), fused aromatics, such as naphthalene, anthracene, phenanthrene, tetracene etc. Further encompassed are biphenyl and oligo- or polyphenyls, such as terphenyl etc. Further encompassed shall be any further aromatic hydrocarbon substituents, such as fluorenyl etc. Arylene, respectively heteroarylene refers to groups to which two further moieties are attached.

The term "heteroaryl" as used herein refers to aryl groups in which at least one carbon atom is substituted by a heteroatom, preferably selected from N, O, S, B or Si.

The term "halogenated" refers to an organic compound in which one hydrogen atom thereof is replaced by a halogen atom. The term "perhalogenated" refers to an organic compound in which all of the hydrogen atoms thereof are replaced by halogen atoms. The meaning of the terms "fluorinated" and "perfluorinated" should be understood analogously.

The subscripted number n in Cₙ-heteroaryl merely refers to the number of carbon atoms excluding the number of heteroatoms. In this context, it is clear that a C₃ heteroarylene group is an aromatic compound comprising three carbon atoms, such as pyrazol, imidazole, oxazole, thiazole and the like.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

The organic semiconducting layer comprising at least one electrical dopant is essentially non-emissive or non-emitting.

With respect to the inventive electronic device, the compounds mentioned in the experimental part may be most preferred.

The inventive electronic device may be an organic electroluminescent device (OLED) an organic photovoltaic device (OPV) or an organic field-effect transistor (OFET).

According to another aspect, the organic electroluminescent device according to the present invention may comprise more than one emission layer, preferably two or three emission layers. An OLED comprising more than one emission layer is also described as a tandem OLED or stacked OLED.

The organic electroluminescent device (OLED) may be a bottom- or top-emission device.

Another aspect is directed to a device comprising at least one organic electroluminescent device (OLED). A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural formula.

The energy levels of the highest occupied molecular orbital, also named HOMO, and of the lowest unoccupied molecular orbital, also named LUMO, are measured in electron volt (eV).

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt.-%", wt%, "percent by weight", "% by weight", and variations thereof refer to a composition, component, substance or agent as the weight of that component, substance or agent of the respective electron transport layer divided by the total weight of the respective electron transport layer thereof and multiplied by 100. It is understood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of", "does not contain", "does not comprise" does not exclude impurities. Impurities have no technical effect with respect to the object achieved by the present invention.

### BRIEF DESCRIPTION OF THE DRAWINGS

These and/or other aspects and advantages of the present invention will become apparent and more readily appreciated from the following description of the exemplary embodiments, taken in conjunction with the accompanying drawings, of which:
FIG. 1 is a schematic sectional view of an organic light-emitting diode (OLED), according to an exemplary embodiment of the present invention;
FIG. 2 is a schematic sectional view of an OLED, according to an exemplary embodiment of the present invention.
FIG. 3 is a schematic sectional view of a tandem OLED comprising a charge generation layer, according to an exemplary embodiment of the present invention.

### EMBODIMENTS OF THE INVENTIVE DEVICE

Reference will now be made in detail to the exemplary embodiments of the present invention, examples of which are illustrated in the accompanying drawings, wherein like reference numerals refer to the like elements throughout. The exemplary embodiments are described below, in order to explain the aspects of the present invention, by referring to the figures.

Herein, when a first element is referred to as being formed or disposed "on" a second element, the first element can be disposed directly on the second element, or one or more other elements may be disposed there between. When a first element is referred to as being formed or disposed "directly on" a second element, no other elements are disposed there between.

FIG. 1 is a schematic sectional view of an organic light-emitting diode (OLED) 100, according to an exemplary embodiment of the present invention. The OLED 100 includes a substrate 110, an anode 120, a hole injection layer (HIL) 130, a hole transport layer (HTL) 140, an emission layer (EML) 150, an electron transport layer (ETL) 160. The electron transport layer (ETL) 160 is formed directly on the EML 150.

Onto the electron transport layer (ETL) 160, an electron injection layer (EIL) 180 is disposed. The cathode 190 is disposed directly onto the electron injection layer (EIL) 180.

Instead of a single electron transport layer 160, optionally an electron transport layer stack (ETL) can be used.

Fig. 2 is a schematic sectional view of an OLED 100, according to another exemplary embodiment of the present invention. Fig. 2 differs from Fig. 1 in that the OLED 100 of Fig. 2 comprises an electron blocking layer (EBL) 145 and a hole blocking layer (HBL) 155.

Referring to Fig. 2, the OLED 100 includes a substrate 110, an anode 120, a hole injection layer (HIL) 130, a hole transport layer (HTL) 140, an electron blocking layer (EBL) 145, an emission layer (EML) 150, a hole blocking layer (HBL) 155, an electron transport layer (ETL) 160, an electron injection layer (EIL) 180 and a cathode electrode 190.

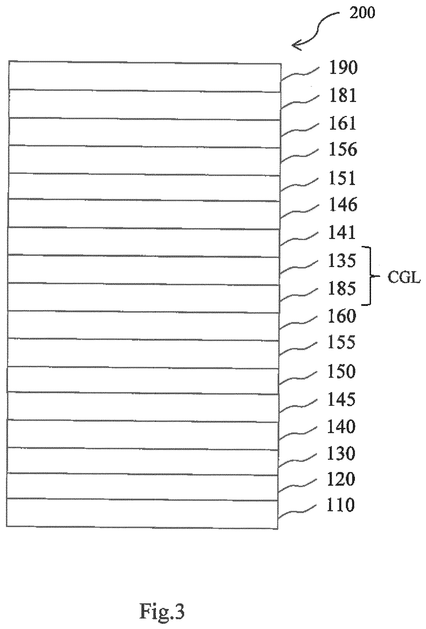

Fig. 3 is a schematic sectional view of a tandem OLED 200, according to another exemplary embodiment of the present invention. Fig. 3 differs from Fig. 2 in that the OLED 100 of Fig. 3 further comprises a charge generation layer and a second emission layer.

Referring to Fig. 3, the OLED 200 includes a substrate 110, an anode 120, a first hole injection layer (HIL) 130, a first hole transport layer (HTL) 140, a first electron blocking layer (EBL) 145, a first emission layer (EML) 150, a first hole blocking layer (HBL) 155, a first electron transport layer (ETL) 160, an n-type charge generation layer (n-type CGL) 185, a hole generating layer (p-type charge generation layer; p-type GCL) 135, a second hole transport layer (HTL) 141, a second electron blocking layer (EBL) 146, a second emission layer (EML) 151, a second hole blocking layer (EBL) 156, a second electron transport layer (ETL) 161, a second electron injection layer (EIL) 181 and a cathode 190.

While not shown in Fig. 1, Fig. 2 and Fig. 3, a sealing layer may further be formed on the cathode electrodes 190, in order to seal the OLEDs 100 and 200. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

### EXPERIMENTAL PART

Preparation of exemplary electrical dopants

K₂[B₁₂F₁₂]

10.62 g (48 mmol) K₂[B₁₂H₁₂] and 23.74 g (409 mmol) KF were suspended in 500 mL acetonitrile with 12 mL water. Under cooling with an ice bath, elemental fluorine (18 volume %) diluted with nitrogen (82 vol. %) was introduced at a flow rate 85 mL/min for overall 14 hours. The reaction mixture was mixed with 80 g sodium hydrogen carbonate and 200 mL water. Organic phase was separated and the aqueous phase was four times extracted with 50 mL acetonitrile. Evaporation of the combined organic phases in vacuo afforded 8.25 g of a solid which was suspended in 50 mL 1M aqueous KOH and extracted 7 times with 15 mL ethyl acetate. Evaporation of combined organic extracts afforded 5.81 g of a solid which was dissolved in 20 mL acetonitrile comprising 5 vol% water. The solution was soaked into 25 cm high alumina column having 2 cm diameter and eluted with ethyl acetate. Evaporation of the eluate afforded 5.20 g the product as solid, yield 5.20 g (25 %).

Li₂[B₁₂F₁₂] (E2)

527 mg (1.2 mmol) K₂[B₁₂F₁₂] were dissolved in 12 mL water and soaked into 20 cm high column of 1 cm diameter, filled with cation exchanger Amberlyst 15 in Li cycle. The column was eluted with 200 mL water and the eluate passed once again through a column filled with fresh Li-saturated cation exchanger. The column was additionally eluted with 200 mL water and combined eluates were evaporated in vacuo, to afford a solid. The crude product was purified on a 15 cm high alumina column having 2 cm diameter, evaporation of the eluate afforded 0.3 g (67 %) product as a solid, ¹¹B-NMR (D₂₀): δ = 18.09; ¹⁹F-NMR (D₂O): δ = 269.32 and 269.47; ⁷Li-NMR (D₂O): δ = 0.19.

Zn[B₁₂F₁₂] (E1)

In a double Schlenk flask provided with a porous glass frit, 504 mg (1.2 mmol) K₂[B₁₂F₁₂] and 404 mg (2.3 mmol) AgNO₃ were dried in high vacuum at room temperature overnight. 4 mL dry acetonitrile were added, the mixture stirred for 30 minutes at room temperature, and formed suspension filtered through the frit, to separate KNO₃ which forms as a colorless solid by-product from the yellowish solution which by evaporation in vacuo afforded 744 mg Ag(CH₃CN)₄[B₁₂F₁₂] as a yellowish solid. The intermediate was dissolved in 150 mL water and threated with 5 g Zn turnings. After 30 minute stirring at room temperature, the excess Zn and dark precipitate of metallic silver which forms as a by-product were separated by filtration thorugh a glass frit, the slightly yellowish clear filtrate was evaporated in vacuo and further dried in vacuo overnight. 453 mg (92 %) of product were obtained as a solid, ¹¹B-NMR (D₂O): δ = 18.09; ¹⁹F-NMR (D₂O): δ = 269.30 and 269.48

In device experiments, compound 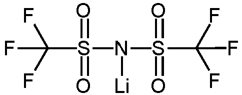 B2, (LiTFSI), CAS 90076-65-6), was used as electrical dopant in comparative example 1.

Exemplary compounds tested as p-dopants were ZnB₁₂F₁₂ 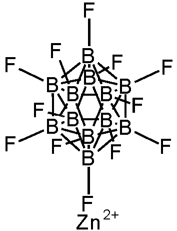 (CAS 1802494-11-6, E1) and Li₂B₁₂F₁₂ 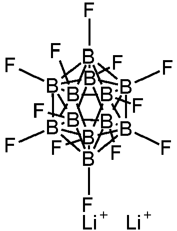 (CAS 522639-16-3, E2)

The formulae of other materials used in the OLED mentioned below are as follows:
F1 is 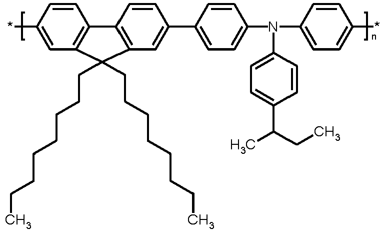
(Poly[(9,9-dioctylfluorenyl-2,7-diyl)-co-(4,4'-(N-(4-sec-butylphenyl)diphenylamine)], commercially available from Solaris Chem Inc. Canada)
F2 is 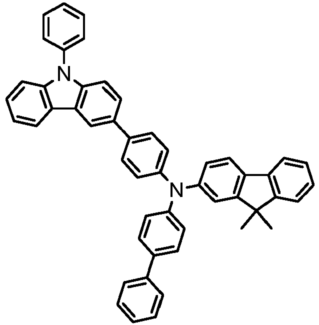 N-([1,1'-biphenyl]-4-yl)-9,9-dimethyl-N-(4-(9-phenyl-9H-carbazol-3-yl)phenyl)-9H-fluoren-2-amine, CAS 1242056-42-3;
F3 is 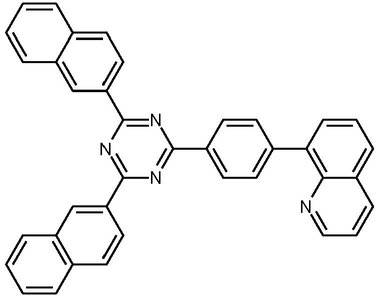 8-(4-(4,6-di(naphthalen-2-yl)-1,3,5-triazin-2-yl)phenyl)quinoline, CAS 1312928-44-1;

ABH-113 is an emitter host and NUBD-370 is a blue fluorescent emitter dopant, both commercially available from SFC, Korea.

ITO is indium tin oxide, LiQ stands for lithium 8-hydroxyquinolinolate

### Standard procedures

### Device preparation

F1 layer comprising the tested and/or comparative electrical dopant was prepared by spin coating; 1.5 wt% F1 stock solution in anisole and 2 wt% stock solution of electrical dopant in benzonitrile were prepared, filtered through PTFE syringe filter having 0.2 µm pore size and mixed in the desired volume ratio before application.

Other layers were deposited by vacuum thermal evaporation (VTE).

### Glass transition temperature

The glass transition temperature is measured under nitrogen and using a heating rate of 10 K per min in a Mettler Toledo DSC 822e differential scanning calorimeter as described in DIN EN ISO 11357, published in March 2010.

### Device examples

Use of a metal borate salt with cluster borate anion as a p-dopant in a hole injection layer comprised in a blue OLED

Table 2a schematically describes the model device.

**Table 2a**

| Material | c [wt%] | d [nm] |
|---|---|---|
| ITO | 100 | 90 |
| F1: p-dopant | 92:8 ( mol%#) | 45 |
| F2 | 100 | 85 |
| ABH113: NUBD370 | 3 | 20 |
| F3: LiQ | 50 | 36 |
| Al | 100 | 100 |

| | | |
|---|---|---|
| #based on molar amount of metal atoms | | |

The results are given in Table 2b

**Table 2b**

| | p-dopant | U* [V] | EQE* [%] | CIE-y* | LT97 |
|---|---|---|---|---|---|
| Comparative example 1 | Li(TFSI) | 4.27 | 6.28 | 0.091 | 20 |
| Example 1 | E1 | 4.13 | 5.86 | 0.093 | 99 |
| Example 2 | E2 | 4.29 | 9.09 | 0.092 | 88 |

| | | | | | |
|---|---|---|---|---|---|
| * j = 15 mA/cm² **j = 30 mA/cm² | | | | | |

As can be seen in Table 2b, the lifetime of OLEDs is significantly improved in Examples 1 and 2 compared to comparative example 1.

The features disclosed in the foregoing description and in the dependent claims may, both separately and in any combination thereof, be material for realizing the aspects of the disclosure made in the independent claims.

Key symbols and abbreviations used throughout the application:
- CV: cyclic voltammetry
- DSC: differential scanning calorimentry
- EBL: electron blocking layer
- EIL: electron injecting layer
- EML: emitting layer
- eq.: equivalent
- ETL: electron transport layer
- ETM: electron transport matrix
- Fc: ferrocene
- Fc⁺: ferricenium
- HBL: hole blocking layer
- HIL: hole injecting layer
- HOMO: highest occupied molecular orbital
- HPLC: high performance liquid chromatography
- HTL: hole transport layer
- p-HTL: p-doped hole transport layer
- HTM: hole transport matrix
- ITO: indium tin oxide
- LUMO: lowest unoccupied molecular orbital
- mol%: molar percent
- NMR: nuclear magnetic resonance
- OLED: organic light emitting diode
- OPV: organic photovoltaics
- PTFE: polytetrafluoroethylene
- QE: quantum efficiency
- R_{f}: retardation factor in TLC
- RGB: red-green-blue
- TCO: transparent conductive oxide
- TFT: thin film transistor
- T_{g}: glass transition temperature
- TLC: thin layer chromatography
- VTE: vacuum thermal evaporation
- wt%: weight percent

## Claims

1. Electronic device comprising, between a first electrode and a second electrode, at least one first semiconducting layer, the first semiconducting layer comprising
(i) at least one first charge transport matrix compound consisting of covalently bound atoms and
(ii) at least one electrical dopant which is non-emissive, wherein the electrical dopant comprises at least one metal cation selected from Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), Al(III); rare earth metal in oxidation state (III), V(III), Nb(III), Ta(III), Cr(III), Mo(III), W(III) Ga(III), In(III); Ti(IV), Zr(IV), Hf(IV) Sn(IV); or a mixture thereof and at least one anionic ligand consisting of covalently bound atoms, wherein the anionic ligand comprises at least two boron atoms linked to each other via a covalent bond,
wherein the first semiconducting layer is a charge injection layer, a part of a charge generating layer, a charge transport layer or two or more thereof; and
the first semiconducting layer is non-emissive.

2. Electronic device according to claim 1, wherein the electrical dopant is a metal salt, a metal complex or a mixture thereof.

3. Electronic device according to claim 1 or 2, wherein the anionic ligand comprises at least 6, alternatively at least 7, alternatively at least 8, alternatively at least 9, alternatively at least 10, alternatively at least 11, alternatively at least 12 covalently bound boron atoms.

4. Electronic device according to any of the preceding claims, wherein the anionic ligand is selected from the group consisting of borate anions, heteroborate anions and mixtures thereof.

5. Electronic device according to any of the preceding claims, wherein the anionic ligand is selected from the group consisting of substituted and unsubstituted closo-dodecaborate dianions.

6. Electronic device according to any of the preceding claims, wherein the anionic ligand comprises substituents independently selected from
(i) H,
(ii) F,
(iii) CN,
(iv) C₆-C₆₀ aryl,
(v) C₇-C₆₀ arylalkyl,
(vi) C₁-C₆₀ alkyl,
(vii) C₂-C₆₀ alkenyl,
(viii) C₂-C₆₀ alkynyl,
(ix) C₃-C₆₀ cycloalkyl and
(x) C₂-C₆₀ heteroaryl;
wherein, with proviso that the overall count of carbon atoms in a carbon-containing group does not exceed 60, any hydrogen atom in any carbon containing group selected from (iv), (v), (vi), (vii), (viii), (ix) and (x) may be replaced by a substituent independently selected from F, Cl, Br, I, CN, unsubstituted or halogenated alkyl, unsubstituted or halogenated (hetero)aryl, unsubstituted or halogenated (hetero)arylalkyl, unsubstituted or halogenated alkylsulfonyl, unsubstituted or halogenated (hetero)arylsulfonyl, unsubstituted or halogenated (hetero)arylalkylsulfonyl, unsubstituted or halogenated boron-containing hydrocarbyl, unsubstituted or halogenated silicon-containing hydrocarbyl.

7. Electronic device according to any of the preceding claims, wherein the anionic ligand comprises at least one substituent selected from Cl, F, Br, I, CN, or an electron-withdrawing carbon group,
wherein the electron-withdrawing carbon group is a carbon group selected from hydrocarbyl, boron-containing hydrocarbyl, silicon-containing hydrocarbyl and heteroaryl and having at least one half of its hydrogen atoms replaced by F, Cl, Br, I CN or a mixture thereof.

8. Electronic device according to any of the preceding claims, wherein the first semiconducting layer comprises a first sub-layer and a second sub-layer, wherein in the first sub-layer, the volume and/or mass fraction of the electrical dopant is higher than the volume and/or mass fraction of all other components comprised in the first sub-layer, and in the second sub-layer, the volume and/or mass fraction of the first charge transport matrix compound is higher than the volume and/or mass fraction of all other components comprised in the second sub-layer.

9. Electronic device according to any of preceding claims, further comprising at least one light emitting layer or at least one light absorbing layer between the first electrode and the second electrode, wherein the first electrode is an anode and the first semiconducting layer is arranged between the anode and the light emitting layer, respectively between the anode and the light absorbing layer.

10. Electronic device according to any of the preceding claims, wherein the electronic device is an electroluminescent device; preferably, the electroluminescent device is an organic light emitting diode.

11. Display device comprising at least two electronic devices according to any of the preceding claims; preferably, the at least two electronic devices comprised in the display device share at least one layer comprising the electrical dopant as defined in claim 1.

12. Semiconducting material comprising
a) at least one first charge transport matrix compound consisting of covalently bound atoms and
b) at least one electrical dopant which is non-emissive, wherein the electrical dopant comprises at least one metal cation selected from Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), Al(III); rare earth metal in oxidation state (III), V(III), Nb(III), Ta(III), Cr(III), Mo(III), W(III) Ga(III), In(III); Ti(IV), Zr(IV), Hf(IV) Sn(IV); or a mixture thereof and at least one anionic ligand consisting of covalently bound atoms, wherein the anionic ligand comprises at least two boron atoms linked to each other via a covalent bond;
wherein the semiconducting material is non-emissive.

13. Method for preparing an electronic device according to any of the claims 1 to 10 comprising a step of depositing the electrical dopant either by vacuum thermal evaporation or from a solution comprising the electrical dopant.

14. Use of a compound comprising at least one metal cation selected from Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), Al(III); rare earth metal in oxidation state (III), V(III), Nb(III), Ta(III), Cr(III), Mo(III), W(III) Ga(III), In(III); Ti(IV), Zr(IV), Hf(IV) Sn(IV); or a mixture thereof and at least one anionic ligand consisting of covalently bound atoms, wherein the anionic ligand comprises at least two boron atoms linked to each other via a covalent bond,
for improving injection and/or transport of electrons ina semiconducting material or in a layer of an electronic device comprising the compound, in comparison with the same semiconducting material and/or layer of the electronic device which does not comprise the compound.

## Patentansprüche

1. Elektronische Vorrichtung, die zwischen einer ersten Elektrode und einer zweiten Elektrode mindestens eine erste halbleitende Schicht umfasst, wobei die erste halbleitende Schicht Folgendes umfasst:
(i) mindestens eine erste Ladungstransportmatrixverbindung, die aus kovalent gebundenen Atomen besteht, und
(ii) mindestens einen elektrischen Dotierstoff, der nicht-emittierend ist, wobei der elektrische Dotierstoff mindestens ein Metallkation umfasst, das ausgewählt ist aus Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), AI(III); Seltenerdmetall im Oxidationszustand (III), V(III), Nb(III), Ta(III), Cr(III), Mo(III), W(III), Ga(III), In(III); Ti(IV), Zr(IV), Hf(IV), Sn(IV); oder einer Mischung davon und mindestens einem anionischen Liganden, der aus kovalent gebundenen Atomen besteht, wobei der anionische Ligand mindestens zwei Boratome umfasst, die über eine kovalente Bindung miteinander verbunden sind,
wobei die erste halbleitende Schicht eine Ladungsinjektionsschicht, ein Teil einer ladungserzeugenden Schicht, eine Ladungstransportschicht oder zwei oder mehr davon ist; und
die erste halbleitende Schicht nicht-emittierend ist.

2. Elektronische Vorrichtung nach Anspruch 1, wobei der elektrische Dotierstoff ein Metallsalz, ein Metallkomplex oder eine Mischung davon ist.

3. Elektronische Vorrichtung nach Anspruch 1 oder 2, wobei der anionische Ligand mindestens 6, alternativ mindestens 7, alternativ mindestens 8, alternativ mindestens 9, alternativ mindestens 10, alternativ mindestens 11, alternativ mindestens 12 kovalent gebundene Boratome umfasst.

4. Elektronische Vorrichtung nach einem der vorhergehenden Ansprüche, wobei der anionische Ligand aus der Gruppe bestehend aus Boratanionen, Heteroboratanionen und Mischungen davon ausgewählt ist.

5. Elektronische Vorrichtung nach einem der vorhergehenden Ansprüche, wobei der anionische Ligand aus der Gruppe bestehend aus substituierten und unsubstituierten *Closo*-Dodecaborat-Dianionen ausgewählt ist.

6. Elektronische Vorrichtung nach einem der vorhergehenden Ansprüche, wobei der anionische Ligand Substituenten umfasst, die unabhängig ausgewählt sind aus
(i) H,
(ii) F,
(iii) CN,
(iv) C₆-C₆₀-Aryl,
(v) C₇-C₆₀-Arylalkyl,
(vi) C₁-C₆₀-Alkyl,
(vii) C₂-C₆₀-Alkenyl,
(viii) C₂-C₆₀-Alkinyl,
(ix) C₃-C₆₀-Cycloalkyl und
(x) C₂-C₆₀-Heteroaryl;
wobei, mit der Maßgabe, dass die Gesamtzahl der Kohlenstoffatome in einer kohlenstoffhaltigen Gruppe 60 nicht überschreitet, jedes Wasserstoffatom in jeder kohlenstoffhaltigen Gruppe, die aus (iv), (v), (vi), (vii), (viii), (ix) und (x) ausgewählt ist, durch einen Substituenten ersetzt sein kann, der unabhängig ausgewählt ist aus F, Cl, Br, I, CN, unsubstituiertem oder halogeniertem Alkyl, unsubstituiertem oder halogeniertem (Hetero)aryl, unsubstituiertem oder halogeniertem (Hetero)arylalkyl, unsubstituiertem oder halogeniertem Alkylsulfonyl, unsubstituiertem oder halogeniertem (Hetero)arylsulfonyl, unsubstituiertem oder halogeniertem (Hetero)arylalkylsulfonyl, unsubstituiertem oder halogeniertem borhaltigem Hydrocarbyl, unsubstituiertem oder halogeniertem siliciumhaltigem Hydrocarbyl.

7. Elektronische Vorrichtung nach einem der vorhergehenden Ansprüche, wobei der anionische Ligand mindestens einen Substituenten umfasst, der aus Cl, F, Br, I, CN oder einer elektronenziehenden Kohlenstoffgruppe ausgewählt ist,
wobei die elektronenziehende Kohlenstoffgruppe eine Kohlenstoffgruppe ist, die aus Hydrocarbyl, borhaltigem Hydrocarbyl, siliciumhaltigem Hydrocarbyl und ausgewählt ist und bei der mindestens die Hälfte ihrer Wasserstoffatome durch F, Cl, Br, I CN oder eine Mischung davon ersetzt ist.

8. Elektronische Vorrichtung nach einem der vorhergehenden Ansprüche, wobei die erste halbleitende Schicht eine erste Teilschicht und eine zweite Teilschicht umfasst, wobei in der ersten Teilschicht der Volumen- und/oder Massenanteil des elektrischen Dotierstoffs höher ist als der Volumen- und/oder Massenanteil aller anderen Komponenten, die in der ersten Teilschicht enthalten sind, und in der zweiten Teilschicht der Volumen- und/oder Massenanteil der ersten Ladungstransportmatrixverbindung höher ist als der Volumen- und/oder Massenanteil aller anderen Komponenten, die in der zweiten Teilschicht enthalten sind.

9. Elektronische Vorrichtung nach einem der vorhergehenden Ansprüche, die ferner mindestens eine lichtemittierende Schicht oder mindestens eine lichtabsorbierende Schicht zwischen der ersten Elektrode und der zweiten Elektrode umfasst, wobei die erste Elektrode eine Anode ist und die erste halbleitende Schicht zwischen der Anode und der lichtemittierenden Schicht bzw. zwischen der Anode und der lichtabsorbierenden Schicht angeordnet ist.

10. Elektronische Vorrichtung nach einem der vorhergehenden Ansprüche, wobei die elektronische Vorrichtung eine Elektrolumineszenzvorrichtung ist; vorzugsweise ist die Elektrolumineszenzvorrichtung eine organische lichtemittierende Diode.

11. Anzeigevorrichtung, die mindestens zwei elektronische Vorrichtungen nach einem der vorhergehenden Ansprüche umfasst; vorzugsweise teilen sich die mindestens zwei elektronischen Vorrichtungen, die in der Anzeigevorrichtung enthalten sind, mindestens eine Schicht, die den elektrischen Dotierstoff wie in Anspruch 1 definiert umfasst.

12. Halbleitendes Material, das Folgendes umfasst:
a) mindestens eine erste Ladungstransportmatrixverbindung, die aus kovalent gebundenen Atomen besteht, und
b) mindestens einen elektrischen Dotierstoff, der nicht-emittierend ist, wobei der elektrische Dotierstoff mindestens ein Metallkation umfasst, das ausgewählt ist aus Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), Al(III); Seltenerdmetall im Oxidationszustand (III), V(III), Nb(III), Ta(III), Cr(III), Mo(III), W(III), Ga(III), In(III); Ti(IV), Zr(IV), Hf(IV), Sn(IV); oder einer Mischung davon und mindestens einem anionischen Liganden, der aus kovalent gebundenen Atomen besteht, wobei der anionische Ligand mindestens zwei Boratome umfasst, die über eine kovalente Bindung miteinander verbunden sind; wobei das halbleitende Material nicht-emittierend ist.

13. Verfahren zum Herstellen einer elektronischen Vorrichtung nach einem der Ansprüche 1 bis 10, das einen Schritt des Abscheidens des elektrischen Dotierstoffs entweder durch thermisches Verdampfen im Vakuum oder aus einer Lösung, die den elektrischen Dotierstoff umfasst, umfasst.

14. Verwendung einer Verbindung, die mindestens ein Metallkation umfasst, das ausgewählt ist aus Li(I), Na(I), K(I), Rb(I), Cs(I); Mg(II), Ca(II), Sr(II), Ba(II), Sn(II), Pb(II), Mn(II), Fe(II), Co(II), Ni(II), Zn(II), Cd(II), Al(III); Seltenerdmetall im Oxidationszustand (III), V(III), Nb(III), Ta(III), Cr(III), Mo(III), W(III), Ga(III), In(III); Ti(IV), Zr(IV), Hf(IV), Sn(IV); oder einer Mischung davon und mindestens einem anionischen Liganden, der aus kovalent gebundenen Atomen besteht, wobei der anionische Ligand mindestens zwei Boratome umfasst, die über eine kovalente Bindung miteinander verbunden sind, zum Verbessern der Injektion und/oder des Transports von Elektronen in einem halbleitenden Material oder in einer Schicht einer elektronischen Vorrichtung, die die Verbindung umfasst, im Vergleich zu dem gleichen halbleitenden Material und/oder der gleichen Schicht der elektronischen Vorrichtung, die die Verbindung nicht umfasst

## Revendications

1. Dispositif électronique comprenant, entre une première électrode et une deuxième électrode, au moins une première couche semi-conductrice, la première couche semi-conductrice comprenant
(i) au moins un premier composé formant une matrice de transport de charge constitué d'atomes liés de manière covalente et
(ii) au moins un dopant électrique qui est non émetteur, dans lequel le dopant électrique comprend au moins un cation métallique choisi parmi Li(I), Na(I), K(I), Rb(I), Cs(I) ; Mg(II), Ca(II), Sr(II), Ba(II), Sn(II), Pb(II), Mn(II), Fe(II), Co(II), Ni(II), Zn(II), Cd(II), Al(III) ; un métal des terres rares à l'état d'oxydation (III), V(III), Nb(III), Ta(III), Cr(III), Mo(III), W(III), Ga(III), In(III) ; Ti(IV), Zr(IV), Hf(IV), Sn(IV) ; ou un mélange de ceux-ci, et au moins un ligand anionique constitué d'atomes liés de manière covalente, dans lequel le ligand anionique comprend au moins deux atomes de bore liés l'un à l'autre par l'intermédiaire d'une liaison covalente,
dans lequel la première couche semi-conductrice est une couche d'injection de charge, une partie d'une couche de génération de charge, une couche de transport de charge ou deux ou plusieurs de celles-ci ; et
la première couche semi-conductrice est non émettrice.

2. Dispositif électronique selon la revendication 1, dans lequel le dopant électrique est un sel métallique, un complexe métallique ou un mélange de ceux-ci.

3. Dispositif électronique selon la revendication 1 ou la revendication 2, dans lequel le ligand anionique comprend au moins 6, ou bien au moins 7, ou bien au moins 8, ou bien au moins 9, ou bien au moins 10, ou bien au moins 11, ou bien au moins 12 atomes de bore liés de manière covalente.

4. Dispositif électronique selon l'une quelconque des revendications précédentes, dans lequel le ligand anionique est choisi dans le groupe constitué par les anions borate, les anions hétéroborate et les mélanges de ceux-ci.

5. Dispositif électronique selon l'une quelconque des revendications précédentes, dans lequel le ligand anionique est choisi dans le groupe constitué par les dianions closo-dodé-caborate substitués et non substitués.

6. Dispositif électronique selon l'une quelconque des revendications précédentes, dans lequel le ligand anionique comprend des substituants choisis indépendamment parmi
(i) H,
(ii) F,
(iii) CN,
(iv) un groupe aryle en C₆ à C₆₀,
(v) un groupe arylalkyle en C₇ à C₆₀,
(vi) un groupe alkyle en C₁ à C₆₀,
(vii) un groupe alcényle en C₂ à C₆₀,
(viii) un groupe alcynyle en C₂ à C₆₀,
(ix) un groupe cycloalkyle en C₃ à C₆₀ et
(x) un groupe hétéroaryle en C₂ à C₆₀ ;
dans lequel, à condition que le nombre total d'atomes de carbone dans un groupe contenant du carbone ne dépasse pas 60, tout atome d'hydrogène dans tout groupe contenant du carbone choisi parmi (iv), (v), (vi), (vii), (viii), (ix) et (x) peut être remplacé par un substituant choisi indépendamment parmi F, CI, Br, I, CN, un groupe alkyle non substitué ou halogéné, un groupe (hétéro)aryle non substitué ou halogéné, un groupe (hétéro)arylalkyle non substitué ou halogéné, un groupe alkylsulfonyle non substitué ou halogéné, un groupe (hétéro)arylsulfonyle non substitué ou halogéné, un groupe (hétéro)arylal-kylsulfonyle non substitué ou halogéné, un groupe hydrocarbyle contenant du bore non substitué ou halogéné, un groupe hydrocarbyle contenant du silicium non substitué ou halogéné.

7. Dispositif électronique selon l'une quelconque des revendications précédentes, dans lequel le ligand anionique comprend au moins un substituant choisi parmi Cl, F, Br, I, CN ou un groupe carboné électroattracteur,
dans lequel le groupe carboné électroattracteur est un groupe carboné choisi parmi un groupe hydrocarbyle, un groupe hydrocarbyle contenant du bore, un groupe hydrocarbyle contenant du silicium et un groupe hétéroaryle, et dont au moins la moitié des atomes d'hydrogène est remplacée par F, Cl, Br, I, CN ou un mélange de ceux-ci.

8. Dispositif électronique selon l'une quelconque des revendications précédentes, dans lequel la première couche semi-conductrice comprend une première sous-couche et une deuxième sous-couche, dans lequel, dans la première sous-couche, la fraction volumique et/ou massique du dopant électrique est supérieure à la fraction volumique et/ou massique de tous les autres composants compris dans la première sous-couche, et dans la deuxième sous-couche, la fraction volumique et/ou massique du premier composé de la matrice de transport de charge est supérieure à la fraction volumique et/ou massique de tous les autres composants compris dans la deuxième sous-couche.

9. Dispositif électronique selon l'une quelconque des revendications précédentes, comprenant en outre au moins une couche émettrice de lumière ou au moins une couche absorbant la lumière située entre la première électrode et la deuxième électrode, dans lequel la première électrode est une anode et la première couche semi-conductrice est disposée entre l'anode et la couche émettrice de lumière, respectivement entre l'anode et la couche absorbant la lumière.

10. Dispositif électronique selon l'une quelconque des revendications précédentes, dans lequel le dispositif électronique est un dispositif électroluminescent ; de préférence, le dispositif électroluminescent est une diode électroluminescente organique.

11. Dispositif d'affichage comprenant au moins deux dispositifs électroniques selon l'une quelconque des revendications précédentes ; de préférence, les au moins deux dispositifs électroniques compris dans le dispositif d'affichage partagent au moins une couche comprenant le dopant électrique tel que défini dans la revendication 1.

12. Matériau semi-conducteur comprenant
a) au moins un premier composé formant une matrice de transport de charge, constitué d'atomes liés de manière covalente, et
b) au moins un dopant électrique qui est non émetteur, dans lequel le dopant électrique comprend au moins un cation métallique choisi parmi Li(I), Na(I), K(I), Rb(I), Cs(I) ; Mg(II), Ca(II), Sr(II), Ba(II), Sn(II), Pb(II), Mn(II), Fe(II), Co(II), Ni(II), Zn(II), Cd(II), Al(III) ; un métal des terres rares à l'état d'oxydation (III), V(III), Nb(III), Ta(III), Cr(III), Mo(III), W(III), Ga(III), In(III) ; Ti(IV), Zr(IV), Hf(IV), Sn(IV) ; ou un mélange de ceux-ci, et au moins un ligand anionique constitué d'atomes liés de manière covalente, dans lequel le ligand anionique comprend au moins deux atomes de bore liés l'un à l'autre par une liaison covalente ; dans lequel le matériau semi-conducteur est non émetteur.

13. Procédé de fabrication d'un dispositif électronique selon l'une quelconque des revendications 1 à 10, comprenant une étape consistant à déposer le dopant électrique soit par évaporation thermique sous vide, soit à partir d'une solution comprenant le dopant électrique.

14. Utilisation d'un composé comprenant au moins un cation métallique choisi parmi Li(I), Na(I), K(I), Rb(I), Cs(I) ; Mg(II), Ca(II), Sr(II), Ba(II), Sn(II), Pb(II), Mn(II), Fe(II), Co(II), Ni(II), Zn(II), Cd(II), Al(III) ; un métal des terres rares à l'état d'oxydation (III), V(III), Nb(III), Ta(III), Cr(III), Mo(III), W(III), Ga(III), In(III) ; Ti(IV), Zr(IV), Hf(IV), Sn(IV) ; ou un mélange de ceux-ci, et au moins un ligand anionique constitué d'atomes liés de manière covalente, dans lequel le ligand anionique comprend au moins deux atomes de bore liés l'un à l'autre par l'intermédiaire d'une liaison covalente,
destiné à améliorer l'injection et/ou le transport d'électrons dans un matériau semi-conducteur ou dans une couche d'un dispositif électronique comprenant le composé, par rapport au même matériau semi-conducteur et/ou à la même couche du dispositif électronique ne comprenant pas le composé.
